(19) **Europäisches Patentamt / European Patent Office / Office européen des brevets**

(11) **EP 1 624 575 B1**

(12) **FASCICULE DE BREVET EUROPEEN**

(45) Date de publication et mention
de la délivrance du brevet:
**28.01.2009 Bulletin 2009/05**

(51) Int Cl.:
***H03L 7/18*** (2006.01)

(21) Numéro de dépôt: **05291578.2**

(22) Date de dépôt: **22.07.2005**

(54) **Architecture de synthétiseur de fréquence**

Frequenzsynthetiser Architektur

Frequency synthesiser architecture

(84) Etats contractants désignés:
**DE FR GB IT**

(30) Priorité: **06.08.2004 FR 0408737**

(43) Date de publication de la demande:
**08.02.2006 Bulletin 2006/06**

(73) Titulaire: **STMicroelectronics SA**
**92120 Montrouge (FR)**

(72) Inventeurs:
• **Ghazali, Mostafa**
**38100 Grenoble (FR)**

• **Jouffre, Pierre-Olivier**
**38000 Grenoble (FR)**

(74) Mandataire: **Bentz, Jean-Paul**
**Novagraaf Technologies**
**122 Rue Edouard Vaillant**
**92593 Levallois-Perret Cedex (FR)**

(56) Documents cités:
**EP-A- 1 298 804        EP-A- 1 300 949**
**WO-A-03/039002        US-A- 5 731 743**
**US-A1- 2002 008 551        US-A1- 2002 121 938**
**US-B1- 6 542 013**

**Description**

La présente invention concerne le domaine des boucles à verrouillage de phase, et en particulier celui des boucles à verrouillage de phase réalisées sous forme de circuit intégré, qui sont typiquement utilisées dans la synthèse haute-fréquence.

Elle concerne plus précisément un synthétiseur de fréquences autorisant un ajustage précis de la fréquence, présentant un rapport signal à bruit élevé et doté de fortes capacités d'intégrabilité.

Une boucle à verrouillage de phase, dite PLL pour « Phase Locked Loop » dans la littérature anglo-saxonne, est généralement très utilisée pour réaliser la synthèse de fréquence. En effet, un tel système permet de multiplier une fréquence de référence par un nombre entier et ainsi d'adresser toute une plage de fréquences avec un certain pas de fréquence. Plus précisément, une boucle à verrouillage de phase est un système d'asservissement générant une fréquence égale à K fois la fréquence de référence qu'il reçoit en entrée. Ainsi, la fréquence de sortie, qui est donnée par un oscillateur commandé en tension, est divisée, puis comparée à une fréquence qui peut être fournie par un quartz. Une pompe de charge, formée de deux sources de courant, réagit alors en injectant ou en retirant du courant dans un filtre intégrateur qui pilote l'oscillateur de sortie.

Cependant, pour avoir une fréquence plus fine en sortie du synthétiseur de fréquences, et donc une plus faible résolution fréquentielle, il est nécessaire d'utiliser des boucles à verrouillage de phase dites « fractionnaires », permettant d'effectuer une division à partie décimale. De tels synthétiseurs de fréquences permettent ainsi de générer des fréquences qui peuvent être ajustées par multiples entiers ou non entiers d'une fréquence de référence.

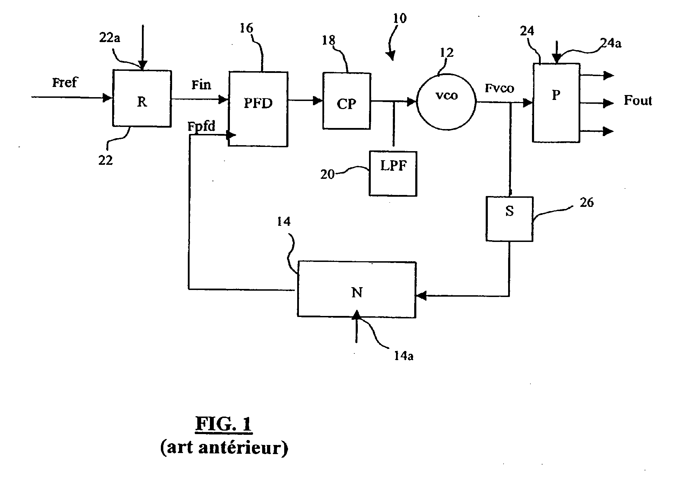

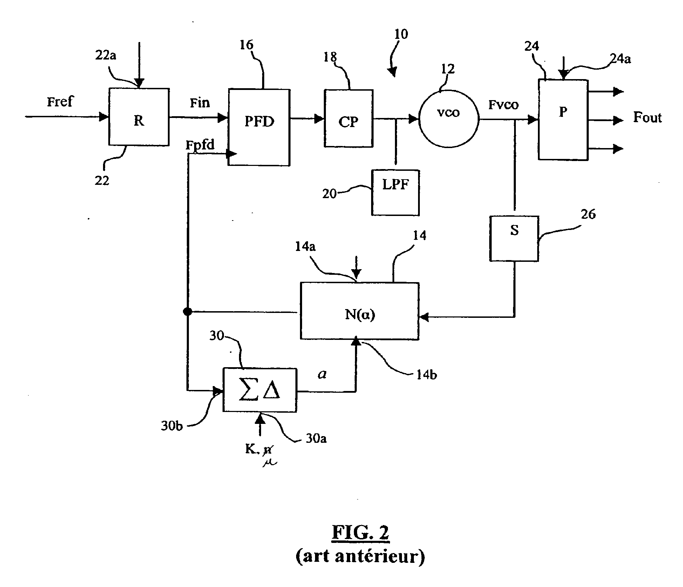

De tels dispositifs tels que décrits ci-dessus sont connus en soi. Les figures 1 et 2 représentent d'ailleurs respectivement un synthétiseur de fréquences classique ajustable par valeurs entières et un synthétiseur de fréquences ajustable par valeurs fractionnaires.

La figure 1 illustre donc la structure d'un synthétiseur de fréquences prévu pour faire de la synthèse haute-fréquence, basée sur une boucle à verrouillage de phase standard programmable 10. La boucle à verrouillage de phase 10 comprend pour l'essentiel un oscillateur commandé en tension (VCO) 12, un diviseur de fréquences 14, un comparateur phase-fréquence (PFD) 16, un circuit de pompe de charge (CP) 18 et un filtre intégrateur passe-bas (LPF) 20. L'oscillateur commandé en tension 12 délivre un signal de sortie Fvco dont la fréquence est de l'ordre du Giga hertz et qui peut être augmentée ou diminuée en fonction d'une tension de commande appliquée à son entrée. Cette tension de commande est générée par le comparateur phase-fréquence 16 et le circuit pompe de charge 18, qui est relié à l'entrée de l'oscillateur 12 par l'intermédiaire du filtre de boucle 18. Le comparateur phase-fréquence compare la fréquence Fpfd (et/ou la phase) d'un signal délivré par le diviseur de fréquence 14 et la fréquence d'un signal de référence Fref, délivré par exemple par un dispositif à quartz. Pour la faisabilité du système, étant donné le contexte synthèse haute-fréquence, un circuit pré-diviseur 26 peut être intégré dans la boucle 10 entre l'oscillateur 12 et le diviseur de fréquence 14. Ce circuit 26 permet d'introduire un facteur de division S de la fréquence du signal Fvco avant d'attaquer le diviseur de fréquence 14.

Un diviseur de fréquence 22 peut être intercalé entre le dispositif à quartz et le comparateur phase-fréquence 16, de sorte que le comparateur phase-fréquence compare le signal Fpfd avec un signal Fin de fréquence égale à une division par un facteur prédéterminé R de la fréquence du signal Fref. Une entrée d'ajustage 22a permet de fixer la valeur R. On peut ainsi faire fonctionner le comparateur de phase à une fréquence beaucoup plus basse que celle du quartz.

Lorsque la fréquence du signal délivré par le diviseur de fréquence 14 est inférieure à celle du signal de référence Fin, le comparateur phase-fréquence 16 commande le circuit de pompe de charge 18, lequel, associé au filtre de boucle 20, fournit une tension commandant l'augmentation de la fréquence de l'oscillateur 12. A l'inverse, la fréquence de l'oscillateur 12 est diminuée lorsque la fréquence du signal délivré par le diviseur de fréquence 14 est supérieure à celle du signal Fin.

Le diviseur de fréquence 14 est un dispositif ne permettant de diviser la fréquence du signal de l'oscillateur 12 que par des valeurs entières. le rapport de division, ajustable par valeurs entières, est donc un nombre entier noté N. Une entrée d'ajustage 14a permet de fixer ce rapport de division.

Egalement, un diviseur de fréquence 24 peut être intercalé à la sortie de l'oscillateur 12, de sorte à obtenir un signal de sortie du synthétiseur de fréquence dont la fréquence Fout est égale à une division par un facteur prédéterminé P de la fréquence du signal Fvco de sortie de l'oscillateur. Une entrée d'ajustage 24a permet de fixer la valeur P

La fréquence de sortie du synthétiseur, notée Fout est donc telle que :

$$Fout = \frac{SxN}{P} xFin$$

et le pas de fréquence en sortie de l'oscillateur 12 est tel que :

$$\Delta Fvco = SxFin \text{ ,}$$

avec

$$Fin = \frac{Fref}{R}$$

La fréquence d'oscillation de l'oscillateur commandé en tension peut donc être ajustée par des pas de fréquence dont la valeur est Fin, si l'on ne tient pas compte du facteur S. Le pas correspond alors à une variation du rapport de division de N à N+1 ou de N à N-1. Pour obtenir un pas de fréquence faible et donc un ajustage relativement précis de la fréquence de boucle, la valeur de la fréquence du signal de référence doit être choisie de préférence faible, à simple titre d'exemple de l'ordre de quelques dizaines de kilo Hertz. Ceci implique de prévoir un filtre de boucle très gros pour maintenir la stabilité de la PLL. Or, un tel filtre empêche de mettre en oeuvre des solutions intégrables. On peut de plus noter qu'une faible fréquence de référence conduit à retenir des valeurs N du rapport de division élevées, ce qui provoque du bruit dans la boucle et dégrade les performances attendues.

Un ajustage beaucoup plus fin de la fréquence du signal de sortie délivré par l'oscillateur commandé en tension, peut être obtenu sans l'inconvénient précité concernant la contrainte du choix d'une valeur relativement faible pour la fréquence de référence, avec un synthétiseur de fréquences conforme à la figure 2.

Le synthétiseur de la figure 2 comprend une boucle à verrouillage de phase 10 dont les éléments en commun avec ceux de la boucle 10 de la figure 1 présentent la même référence.

Le diviseur de fréquence 14 présente en revanche, non seulement une entrée d'ajustage 14a pour fixer la valeur du rapport de division N, mais également une entrée de commutation 14b pour commuter le rapport de division entre deux ou plusieurs valeurs consécutives autour de la valeur N, par exemple entre deux valeurs qui sont N et N+1. L'entrée de commutation 14b est connectée à un modulateur sigma-delta 30, qui se présente sous la forme d'un modulateur numérique d'ordre 1, 2 ou 3 et qui va permettre de modifier le rapport de division au niveau du diviseur 14. Le modulateur sigma-delta 30 présente une première entrée numérique 30a pour recevoir une consigne d'ajustage notée K, codée sur u bits. Il comprend une deuxième entrée 30b, connectée en sortie du diviseur 14, dont le signal de sortie est utilisé pour cadencer le modulateur.

Le diviseur de fréquence 14 est conçu de façon à effectuer une division de fréquences avec un premier rapport de division lorsque son entrée de commutation 14b reçoit un premier état logique fourni par le modulateur sigma-delta et de façon à effectuer une division avec un deuxième rapport de division, lorsque l'entrée 14b reçoit un deuxième état logique de commutation du modulateur sigma-delta. Par exemple, le rapport de division est N pour le premier état logique et est N+1 pour le second état logique. Bien qu'à tout instant le rapport de division du diviseur de fréquence 14 soit un nombre entier, la commutation répétée du rapport entre N et N+1 permet d'obtenir un rapport de division moyen résultant $\alpha$ compris entre ces deux valeurs, c'est à dire un nombre non entier.

Plus précisément, en considérant que la consigne d'ajustage K appliquée à la première entrée 30a du modulateur sigma-delta est codée sur u bit, on peut définir une partie fractionnaire du rapport de division du diviseur 14 réalisée par le modulateur, égale à $\dfrac{K}{2^u}$ .

Ainsi, le rapport de division $\alpha$, comprenant la partie entière N et la partie fractionnaire réalisée par le modulateur, peut s'écrire :

$$\alpha = N + \frac{K}{2^u}$$

La fréquence de sortie du synthétiseur est donc telle que :

$$Fout = \frac{\alpha x S}{P} xFin$$

et le pas de fréquence en sortie de l'oscillateur commandé en tension :

$$\Delta Fvco = \frac{SxFin}{2^u}$$

Il est ainsi possible d'ajuster continûment la fréquence de la boucle à verrouillage de phase entre deux valeurs fixées par le choix du rapport de division N appliquée à l'entrée d'ajustage 14a du diviseur de fréquences 14 et par le choix de la consigne d'ajustage K appliquée au modulateur sigma-delta. Il ressort de la formule ci-dessus que le pas d'ajustage peut être aussi fin que Fin/$2^u$, au facteur S près. Pour un codage de la consigne d'ajustage K du modulateur sigma-delta sur 8 ou 16 bits, c'est-à-dire pour u = 8 ou u = 16 par exemple, l'ajustage peut être presque continu et ce, de façon quasi indépendante de la fréquence de référence. Cette solution permet donc, grâce à l'algorithme mis en oeuvre par le modulateur sigma-delta, d'obtenir une bonne résolution sans avoir à descendre bas en fréquence de référence, comme pour la première solution.

Cependant, le modulateur sigma-delta génère une puissance de bruit importante dans la boucle, susceptible de provoquer des fluctuations indésirables de la phase du signal fourni par l'oscillateur commandé en tension. Un tel comportement va dégrader le rapport signal à bruit du système, alors qu'un rapport signal à bruit élevé est absolument nécessaire pour garantir de bonnes performances au système, tout particulièrement pour les applications large bande.

Il est possible de compenser le bruit introduit par l'algorithme du modulateur sigma-delta, en coupant bas au niveau du filtre de boucle, de façon à rejeter au maximum le bruit de la bande de fréquence utile. Toutefois, si la fréquence de coupure du filtre de boucle est abaissée à cet effet, c'est le bruit de phase de l'oscillateur commandé en tension qui prend alors trop d'importance au regard des performances attendues du système, notamment dans le cadre des applications large bande où sont mis en oeuvre de tels synthétiseurs. L'architecture présentée en référence à la figure 2 rend donc très difficile l'obtention d'un compromis acceptable entre le bruit de l'algorithme du modulateur sigma-delta et le bruit de phase de l'oscillateur commandé en tension, ce que vise précisément à obtenir l'invention.

Le document WO 03039002 A2 montre un synthétiseur de fréquence comprenant toutes les caractéristiques du préambule de la présente revendication 1.

La présente invention a ainsi pour but de proposer une nouvelle architecture de synthétiseur de fréquence, ne présentant pas les limitations évoquées ci-dessus en rapport aux architectures de synthétiseur de fréquences de l'art antérieur.

Un but en particulier est de proposer un synthétiseur de fréquence du type à diviseur fractionnaire, c'est-à-dire avec un algorithme numérique dans la boucle, capable d'assurer une très bonne précision de la fréquence générée avec un ajustement précis de celle-ci, tout en présentant un bruit de phase particulièrement réduit, garantissant ainsi de bonnes performances au système quant au rapport signal à bruit obtenu.

Un autre but de l'invention est de proposer un tel synthétiseur qui soit complètement intégrable.

Avec ces objectifs en vue, l'invention a pour objet un synthétiseur de fréquence comportant une boucle à verrouillage de phase comprenant un comparateur de phase dont une première entrée est reliée à une source de signal de référence, un oscillateur commandé en tension associé à des moyens de modulation présentant un rapport de division global dont le produit par la fréquence du signal de référence fournit la fréquence de sortie désirée, lesdits moyens de modulation comprenant un circuit diviseur de fréquence pour diviser la fréquence du signal de sortie de l'oscillateur par un facteur de division entier N, ajustable, et dont la sortie est reliée à l'autre entrée du comparateur de phase, ledit synthétiseur étant caractérisé en ce qu'il comprend en outre des moyens de génération de phases, connectés entre l'oscillateur et les moyens de modulation, pour générer un nombre prédéterminé de phases synchronisées sur la fréquence dudit oscillateur et espacées les unes des autres d'un écart temporel représentatif de l'erreur de phase mesurée par le comparateur de phase,

lesdits moyens de modulation comprenant des moyens d'élaboration aptes à élaborer un signal intermédiaire à partir desdites phases, dont la période est dépendante dudit écart temporel entre les phases et d'un premier paramètre de réglage MD fourni audits moyens d'élaboration par des moyens de commande desdits moyens d'élaboration, ledit signal intermédiaire étant appliqué au circuit diviseur par N,

et des moyens de correction aptes à déterminer l'erreur de phase accumulée au cours de N-1 périodes dudit signal intermédiaire et à effectuer une correction dudit signal intermédiaire toutes les N périodes dudit signal intermédiaire en fonction de ladite erreur de phase accumulée, conduisant à une stabilité de la boucle.

Les moyens de commande des moyens d'élaboration du signal intermédiaire comprennent un circuit additionneur, dont une première entrée reçoit le premier paramètre de réglage et une deuxième entrée est connectée aux moyens de correction, la sortie du circuit additionneur étant connectée à un circuit décodeur pour commander les moyens d'élaboration sur la base de l'information fournie par ledit circuit additionneur.

Les moyens de correction sont connectés en sortie à la deuxième entrée du circuit additionneur des moyens de commande par l'intermédiaire de moyens de sélection, lesdits moyens de sélection étant cadencés par le signal de sortie du circuit diviseur par N, de sorte à ce que la sortie desdits moyens de correction soit sélectionnée et fournie audit circuit additionneur une fois toutes les N périodes du signal intermédiaire pendant une période dudit signal intermédiaire.

Les moyens de correction comprennent un modulateur sigma-delta , cadencé par le signal de sortie du circuit diviseur par N, ledit modulateur comprenant une entrée pour recevoir un deuxième paramètre de réglage PE codé sur n bits et définissant une partie fractionnaire ajustable du rapport de division, la sortie dudit modulateur sigma-delta étant connectée à une première entrée d'un circuit additionneur recevant sur une seconde entrée un troisième paramètre de réglage MDC, la sortie dudit circuit additionneur étant connectée aux moyens de sélections .

Avantageusement, la sortie des moyens d'élaboration du signal intermédiaire est rebouclée vers les moyens de commande desdits moyens d'élaboration, de sorte à ce que lesdits moyens de commande soient cadencés à la fréquence du signal intermédiaire généré.

De préférence, les moyens d'élaboration du signal intermédiaire comprennent un circuit multiplexeur.

De préférence, le modulateur sigma-delta est un modulateur d'ordre 2, la détermination des premier et troisième paramètres de réglage, respectivement MD et MDC est telle que :

$MD + MDC \leq nt$ - 2, avec nt le nombre de phases générées par les moyens de génération de phase.

Le rapport de division global est tel que :

$$\beta = \frac{N \times MD + MDC + \dfrac{PE}{2^n}}{nt} ,$$

avec nt le nombre de phases générées par les moyens de génération de phase (50).

De préférence, un circuit diviseur de fréquence introduisant un facteur de division D est intercalé entre la sortie des moyens de modulation et l'autre entrée du comparateur de phase.

Selon une variante, le modulateur sigma-delta est inhibé ou supprimé.

Selon cette variante, la détermination des premier et troisième paramètres de réglage, respectivement MD et MDC est telle que :

$MD + MDC \leq nt$, avec nt le nombre de phases générées par les moyens de génération de phase.

Le rapport de division global est alors tel que :

$$\beta = \frac{N \times MD + MDC}{nt} ,$$

avec nt le nombre de phases générées par les moyens de génération de phase.

De préférence, les moyens de génération de phase comprennent un circuit diviseur de fréquence, introduisant un facteur de division prédéterminé dans la boucle.

De préférence, un circuit diviseur de fréquence est connecté à la première entrée du comparateur de phase, de sorte à pouvoir abaisser la fréquence du signal de référence d'un facteur prédéterminé.

De préférence, un circuit diviseur de fréquence est connecté en sortie de l'oscillateur, de sorte que la fréquence de sortie désirée dudit synthétiseur est égale à une division par un facteur prédéterminé de la fréquence de sortie de l'oscillateur.

De préférence, le synthétiseur de fréquence est réalisé sous la forme d'un circuit intégré.

D'autres caractéristiques et avantages de la présente invention apparaîtront plus clairement à la lecture de la description suivante donnée à titre d'exemple illustratif et non limitatif et faite en référence aux figures annexées dans lesquelles :

- la figure 1, déjà décrite, est un schéma d'un synthétiseur de fréquence basé sur une boucle à verrouillage de phase standard programmable,
- la figure 2, déjà décrite est un schéma d'un synthétiseur de fréquence basé sur une boucle à verrouillage de phase de type fractionnaire,
- la figure 3 est un schéma d'un synthétiseur de fréquence conforme à l'invention,
- la figure 4 est un schéma détaillé du modulateur utilisé dans le dispositif de la figure 3,
- la figure 5 illustre un fonctionnement des moyens de modulation mis en oeuvre à partir des chronogrammes des signaux Fs et Fin.

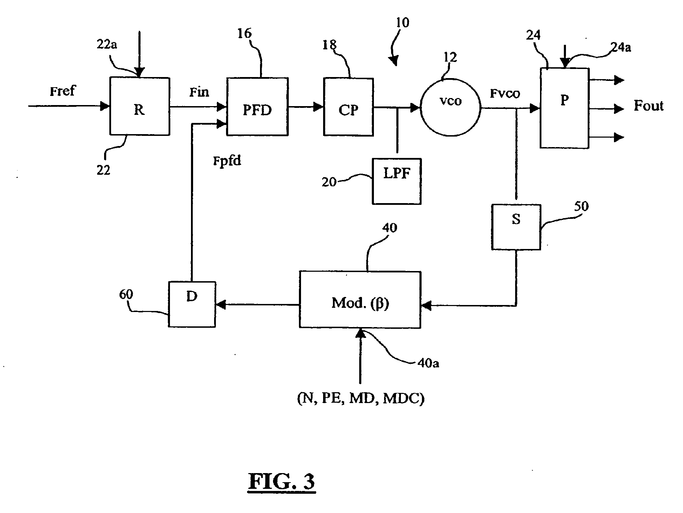

La figure 3 illustre donc le schéma d'un synthétiseur de fréquence conforme à la présente invention, basé sur une PLL fractionnaire par division améliorée. Les éléments en commun avec les synthétiseurs de fréquence de l'art antérieur déjà décrits portent les mêmes références.

Ainsi, conformément à l'invention, la boucle à verrouillage de phase intègre dorénavant des moyens de modulation 40 particuliers, présentant un rapport de division global β, dont le produit par la fréquence du signal de référence Fin appliqué sur la première entrée du comparateur de phase 16 fournit la fréquence de sortie Fvco désirée en sortie de l'oscillateur 12. Comme déjà vu en référence aux architectures précédentes, un diviseur de fréquence 22 peut être intercalé entre un dispositif à quartz fournissant un signal de référence Fref et le comparateur de phase 16, de sorte que le comparateur de phase compare le signal Fpfd avec un signal de référence Fin de fréquence égale à une division par un facteur prédéterminé R de la fréquence du signal Fref. On peut ainsi faire fonctionner le comparateur de phase à une fréquence plus basse que celle du quartz.

Egalement, un diviseur de fréquence 24 peut être intercalé à la sortie de l'oscillateur 12, de sorte à obtenir un signal de sortie du synthétiseur de fréquence dont la fréquence Fout est égale à une division par un facteur prédéterminé P de la fréquence du signal Fvco de sortie de l'oscillateur.

Egalement, un circuit pré-diviseur 50 peut être intégré dans la boucle entre l'oscillateur 12 et le bloc de modulation 40. Ce circuit 50 permet d'introduire un facteur de division S au niveau de la fréquence du signal Fvco avant d'attaquer le bloc de modulation 40.

Enfin, un circuit diviseur de fréquence 60 peut aussi être intercalé entre la sortie des moyens de modulation 40 et l'entrée du comparateur de phase 16 à laquelle la sortie des moyens de modulation est connectée. Ce circuit diviseur introduit alors un facteur de division D de la fréquence du signal de sortie des moyens de modulation, de préférence égal à deux, et permet d'améliorer la performance du système.

Ainsi, dans cette configuration, la fréquence de sortie Fout du synthétiseur de fréquence s'écrit :

$$Fout = \frac{D \times \beta \times S}{R \times P} \times Fref$$

Le rapport de division global β est quant à lui défini par un ensemble de paramètres de réglage, respectivement MD, MDC, PE et N, qui seront décrits plus précisément ci-après et qui sont fournis en entrée du bloc de modulation 40, permettant ainsi de programmer ce dernier conformément aux performances voulues par l'utilisateur.

Typiquement, le fonctionnement d'un synthétiseur de fréquence comporte cycliquement une succession d'une phase de mesure et d'une phase de correction. La phase de mesure comporte selon l'art antérieur au moins une première division de la fréquence du signal de sortie de l'oscillateur de façon à obtenir un signal intermédiaire, puis, on détermine un premier signal de mesure au niveau du comparateur de phase, représentatif de l'écart temporel entre ce premier signal intermédiaire et le signal de référence, autrement dit de l'erreur de phase entre ces deux signaux. La correction consiste alors en une correction de la commande de l'oscillateur conformément au signal d'erreur.

Toutefois, la détermination de l'erreur de phase que l'on souhaite corriger est basée sur une période entière du signal de sortie de l'oscillateur. L'invention propose un fonctionnement très différent. Ainsi, des moyens de génération de phases 50 sont mis en oeuvre entre la sortie de l'oscillateur 12 et le bloc de modulation 40.

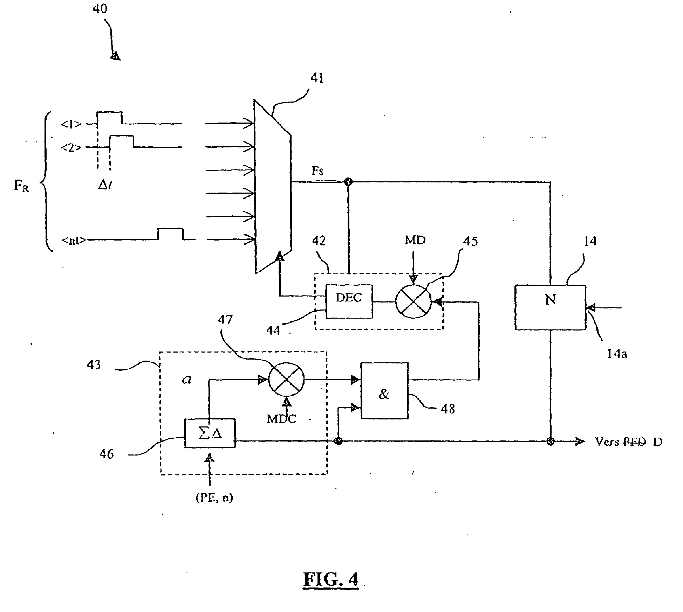

Comme le montre la figure 4, on génère un nombre nt de phases. Typiquement, on va utiliser le processus de division de fréquence mis en oeuvre par le circuit 50 pour générer ces phases à partir du signal de sortie de l'oscillateur, par des techniques connues en soi qu'il n'est pas utile de détailler davantage dans le cadre de la présente description. Toutefois, la génération de phases peut être faite selon d'autres méthodes, sans l'obligation d'introduire un facteur de division prédéterminé S. Le VCO 12 peut par exemple générer nt/2 phases, puis à l'aide d'un interpolateur analogique ou numérique, doubler ce nombre de phase par 2 pour atteindre les nt phases souhaitées et ceci, sans forcement introduire un facteur de division (S).

Plus précisément, on obtient nt phases décalées les unes des autres d'un temps $\Delta t$ connu, représentatif de l'erreur de phase mesurée par le comparateur de phase. Ainsi, ce délai entre les phases correspond au délai que l'on veut récupérer au moment de la comparaison de phase au niveau du bloc 16. Le nombre nt de phases obtenues est lié à la division effectuée entre l'oscillateur et le bloc de modulation 40. Ces phases, toutes à la fréquence constante $F_R$, sont complètement synchronisées avec la fréquence de l'oscillateur. On conserve ainsi la précision de l'oscillateur, qui travaille haut en fréquence, par exemple dans la bande de fréquence 2 à 5 Giga Hertz.

L'erreur de phase que l'on veut corriger correspond ainsi à l'écart temporel $\Delta t$ entre les phases et les cycles de mesure sont alors basés sur la pluralité de phases générées décalées les unes des autres de $\Delta t$.

La figure 4 est donc un schéma détaillé des moyens de modulation 40 mis en oeuvre dans le dispositif de la figure 3. Les moyens de modulation 40 reçoivent donc en entrée la pluralité de phases générées. Les moyens de modulation 40 comprennent un multiplexeur 41, recevant les nt fréquences sur autant d'entrées correspondantes du multiplexeur. Le multiplexeur permet de reconstituer à partir des nt phases, un signal intermédiaire à une fréquence stable Fs plus élevée ou égale à la fréquence des phases. Pour ce faire, des moyens de commande 42 du multiplexeur sont prévus. Plus précisément, les moyens de commande 42 comprennent un additionneur 45 recevant sur une première entrée un premier paramètre de réglage MD, et un circuit décodeur 44, pour commander le multiplexeur sur la base de l'information qui lui est fournie par l'additionneur 45. La sortie du multiplexeur est rebouclée au niveau de ses moyens de commande.

Ainsi, la fréquence de sortie générée par le multiplexeur est utilisée pour cadencer l'additionneur 45, qui commande le circuit décodeur 44 permettant de sélectionner à chaque impulsion une des entrées du multiplexeur parmi les nt. Dans un premier temps, le système boucle donc avec le paramètre de réglage MD pour élaborer le signal intermédiaire à la fréquence Fs, qui est liée à l'écart temporel Δt entre les phases et au paramètre de réglage MD. Le signal intermédiaire Fs est appliqué au sein dé l'étage 40 à un circuit diviseur de fréquence 14, permettant de diviser la fréquence du signal intermédiaire Fs par un facteur de division N entier, et dont la sortie est envoyée vers le circuit comparateur de phase, éventuellement par l'intermédiaire du circuit diviseur 60 par D.

Le signal intermédiaire Fs divisé par N, est également utilisé pour cadencer un modulateur sigma-delta 46. ce modulateur comprend une entrée pour recevoir un deuxième paramètre de réglage PE, codé sur n bits, et définissant une partie fractionnaire ajustable du rapport de division global égale à $PE/2^n$. Ce bloc réalise donc la partie fractionnaire et l'algorithme numérique mis en oeuvre peut être d'un ordre 1, 2 ou 3 pour ce type de PLL.

Il est à noter que le partie entière N est également programmable. Toutefois, elle ne peut être programmée à la volée, commandée par l'algorithme du modulateur sigma-delta, comme c'est le cas dans les architectures de PLL fractionnaire par division de l'art antérieur.

La sortie du modulateur sigma-delta est connectée à une première entrée d'un circuit additionneur 47, recevant sur une seconde entrée un troisième paramètre de réglage MDC, la sortie dudit circuit additionneur 47 étant connectée à une deuxième entrée du circuit additionneur 45 des moyens de commande 42 du multiplexeur, par l'intermédiaire de moyens de sélections 48. L'ensemble formé par le modulateur sigma delta 46 et le circuit additionneur 47 recevant sur une première entrée le paramètre MDC, forme en fait un bloc de correction 43 au niveau de la boucle, dont le rôle consiste plus particulièrement à déterminer l'erreur de phase accumulée au cours de N-1 périodes du signal intermédiaire par rapport à la fréquence que l'on veut obtenir en sortie du synthétiseur et à corriger le signal intermédiaire pour tenir compte de cette erreur.

Selon l'invention, on effectue cette correction toutes les N pulsations du signal Fs. Ainsi, les moyens de sélection 48 sont cadencés par le signal de sortie du circuit diviseur par N, de façon à ce que la sortie des moyens de correction 43, constituée par la sortie du circuit additionneur 47, soit sélectionnée par le circuit de sélection 48 et fournie au circuit additionneur 45 des moyens de commande du multiplexeur une fois toutes les N périodes du signal Fs. De cette manière, les paramètres MDC+a (a représentant la variation apportée par le modulateur sigma-delta 46 tous les N pulsations du signal Fs, « a » dépendant du type et de l'ordre du modulateur, soit par exemple a = 2, 1, 0 ou -1 pour un modulateur sigma delta multibit d'ordre 2) sont sélectionnés pendant une période entière Ts correspondant à une durée haute du signal divisé, grâce aux moyens de sélection 48, et sont additionnés au premier paramètre de réglage MD une fois toutes les N périodes du signal Fs.

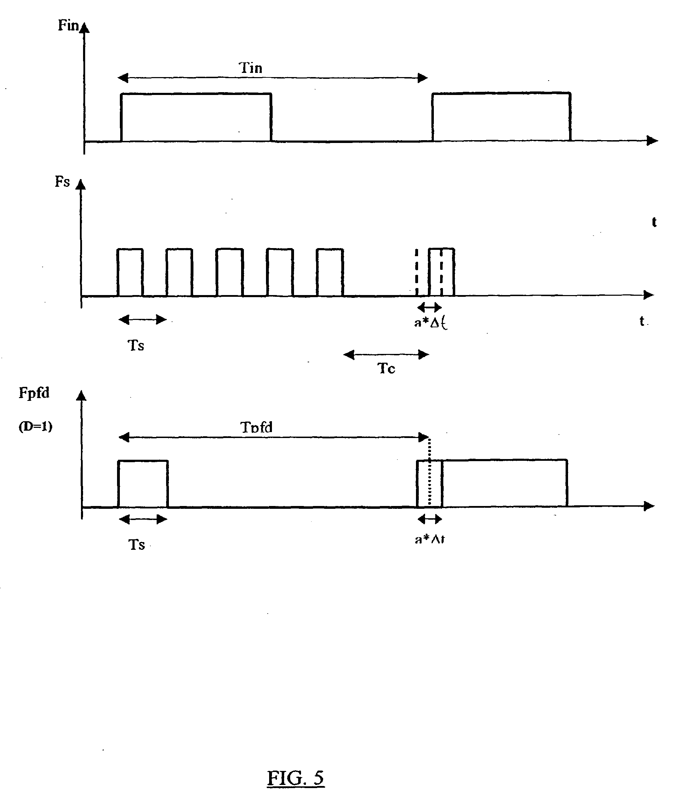

En effet, comme l'illustre la figure 5 pour D=1, présentant un chronogramme d'un signal créé Fs et d'un signal de référence Fin, en partant d'une fréquence théorique correspondant à la fréquence du signal Fs, les calculs montrent que l'on fait une variation de $a^*\Delta t$ autour de la période du signal Fin sur laquelle on souhaite se caler, variation dont la valeur moyenne vaut $PE/2^n$. Ainsi, selon le principe de l'invention, on récupère cette erreur de phase accumulée Tc-Ts pendant les N-1 pulsations du signal Fs, puis on ajoute celle-ci a la Nième pulsation du signal Fs de période Ts. Ceci est permis grâce au bloc de correction 43 mettant en oeuvre le modulateur sigma delta associé paramètre de réglage MDC.

On a donc DxN fronts du signal Fs pendant la durée Tin. Ainsi :

$$\texttt{Tin=Dx[(N-1)xTs+Tc], et Tc=(MD+MDC+PE/}2^n\texttt{)}\Delta\texttt{t}$$

$$\texttt{Ts=MDx }\Delta\texttt{t}$$

Soit : $Tin=Dx[NxTs + (MDC+PE/2^n)\Delta t]$, la deuxième partie de cette équation correspondant donc au saut supplémentaire nécessaire pour atteindre Tin, généré grâce à l'algorithme du modulateur sigma-delta associé au paramètre de réglage MDC.

Selon cette caractéristique de l'invention, on fait donc réagir l'algorithme du modulateur sigma-delta une fois seulement toutes les N périodes de Fs, ce qui permet avantageusement de ramener au final, à l'entrée du circuit PFD 16, un signal Fpfd ne présentant qu'une faible erreur de phase de $a^*\Delta t$ à corriger, et de réduire ainsi la puissance de bruit produite par le modulateur sigma-delta dans la boucle. En diminuant ainsi la puissance de bruit introduite par le modulateur sigma-delta, on n'est plus contraint de filtrer aussi bas en fréquence au niveau du filtre de boucle, contrairement aux architectures de l'art antérieur ramenant à l'entrée du PFD une erreur de phase de $a^*S^*Tvco$. Cette diminution de bruit permet un compromis très acceptable entre le bruit de l'oscillateur et le bruit généré par le modulateur sigma-delta. En effet, avec la configuration proposée, une fréquence de coupure plus élevée pour le filtre de boucle permet de filtrer efficacement les raies parasites inhérentes aux boucles à verrouillage de phase fractionnaires classiques, mais il permet également de rejeter significativement le bruit de phase généré par l'oscillateur. Par conséquent, les performances en rapport signal à bruit en sont accrues.

Selon le mode de réalisation de la figure 4, on obtient les caractéristiques principales suivantes :

Le rapport de division global comprenant la partie entière plus la partie fractionnaire :

$$\beta = \frac{N \times MD + MDC + \dfrac{PE}{2^n}}{nt}$$

Le pas de fréquence minimum en sortie de l'oscillateur :

$$\Delta_{Fvco} = \frac{D \times S \times Fref}{R \times nt \times 2^n}$$

Le bon fonctionnement du synthétiseur de fréquences de la figure 4 avec les caractéristiques telles que définies ci-dessus étant soumis au respect de l'inégalité suivante pour un modulateur d'ordre 2 :

$$MD + MDC \leq nt - 2$$

En prenant un facteur de division D=1 pour le diviseur 60 dans la boucle et en comparant les performances en bruit de phase d'une boucle à verrouillage de phase fractionnaire par division classique et d'une boucle à verrouillage de phase fractionnaire par division et multiplexage selon l'invention, on améliore le rapport signal à bruit de environ 19dB sur une bande de +/-25MHz. Cette comparaison a été obtenue en prenant les mêmes spécifications pour les deux boucles, notamment une même fréquence de référence Fref, une même fréquence de coupure Fc, un même type de modulateur sigma delta, un même diviseur d'entrée R, un même diviseur de sortie avec P, et un même facteur de division S. On a également pris comme hypothèse de pouvoir synthétiser une fréquence Fout=2.5GHz, avec une même résolution fréquentielle pour les deux boucles.

Pour un facteur de division D=2 dans la boucle, on améliore le rapport signal à bruit de environ 24dB sur une bande de +/-25MHz.

Si l'on voulait atteindre des performances semblables pour D=1 avec une PLL fractionnaire classique par division, il faudrait multiplier la taille du filtre par 64. Ce choix imposerait alors de disposer du filtre à l'extérieur du circuit. Pour D=2, avec une PLL fractionnaire classique par division, il faudrait multiplier la taille du filtre par 256.

Enfin, selon un mode de réalisation particulier de la présente invention, il est possible de transformer le fonctionnement de la PLL fractionnaire par division et multiplexage selon l'invention décrite aux figures 3 et 4, en celui d'une PLL programmable standard. Pour ce faire, le sous-ensemble 46 du modulateur réalisant la partie fractionnaire $PE/2^n$ est inhibée ou supprimée. On ne garde alors que les paramètres de réglage utilisés pour le codage de la partie entière du rapport de division global β, à savoir N, MD et MDC. Dans ce mode de réalisation, le facteur de division D est pris égal à 1.

Selon ce mode de réalisation particulier, on obtient les caractéristiques principales suivantes :

Le rapport de division global comprenant uniquement une partie entière :

$$\beta = \frac{N \times MD + MDC}{nt}$$

Le pas de fréquence minimum en sortie de l'oscillateur :

$$\Delta_{Fvco} = \frac{S \times Fref}{R \times nt}$$

Le bon fonctionnement du synthétiseur de fréquences selon ce mode de réalisation particulier avec les caractéristiques telles que définies ci-dessus étant soumis au respect de l'inégalité suivante:

$$MD + MDC \leq nt$$

Le synthétiseur de fréquence selon la présente invention permet donc de réaliser une boucle à verrouillage de phase fractionnaire par division programmable ou bien une boucle à verrouillage de phase standard programmable et ce, avec des caractéristiques de performances de bruit de phase et en terme de surface, donc de coût, nettement améliorées par rapport aux architectures de l'art antérieur pour ce type de PLL.

## Revendications

1.  Synthétiseur de fréquence comportant une boucle à verrouillage de phase (10) comprenant

    - un comparateur de phase (16) dont une première entrée est reliée à une source de signal de référence,
    - un oscillateur commandé en tension (12)
    - des moyens de modulation (40) présentant un rapport de division global (β) dont le produit par la fréquence du signal de référence (Fin) fournit la fréquence de sortie désirée (Fout), lesdits moyens de modulation comprenant un circuit diviseur de fréquence (14) pour diviser la fréquence du signal de sortie de l'oscillateur par un facteur de division entier N, ajustable, et dont la sortie est reliée à l'autre entrée du comparateur de phase, ledit synthétiseur comprenant en outre des moyens de génération de signaux (50), connectés entre l'oscillateur et les moyens de modulation, pour générer un nombre prédéterminé de signaux synchronisés sur la fréquence dudit oscillateur et dont les phases sont espacées les unes des autres d'un écart temporel (Δt) représentatif de l'erreur de phase mesurée par le comparateur de phase, lesdits moyens de modulation comprenant :

        - des moyens d'élaboration (41) aptes à élaborer, à partir desdits signaux, un signal intermédiaire (Fs) prévu pour être appliqué au circuit diviseur par N, dont la période est dépendante dudit écart temporel (Δt) entre les phases et d'un premier paramètre de réglage MD,
        - des moyens de commande (42) desdits moyens d'élaboration, comprenant un premier circuit additionneur (45), dont une première entrée reçoit le premier paramètre de réglage (MD) et dont la sortie est connectée à un circuit décodeur (44) pour commander les moyens d'élaboration (41) sur la base de l'information fournie par le premier circuit additionneur, ,
        - des moyens de correction (43) aptes à déterminer l'erreur de phase accumulée au cours de N-1 périodes dudit signal intermédiaire et à effectuer une correction dudit signal intermédiaire toutes les N périodes dudit signal intermédiaire en fonction de ladite erreur de phase accumulée, lesdits moyens de correction comprenant un modulateur sigma-delta prévu pour être cadencé par le signal de sortie du circuit diviseur par N,

        **caractérisé en ce que** ledit modulateur sigma-delta des moyens de correction comprend en outre une entrée pour recevoir un deuxième paramètre de réglage PE codé sur n bits et définissant une partie fractionnaire ajustable du rapport de division, la sortie dudit modulateur sigma-delta étant connectée à une première entrée d'un second circuit additionneur (47) recevant sur une seconde entrée un troisième paramètre de réglage MDC, la sortie dudit second circuit additionneur (47) étant connectée à une deuxième entrée du premier circuit additionneur (45) par l'intermédiaire de moyens de sélection (48) cadencés par le signal de sortie du circuit diviseur par N (14).

2.  Synthétiseur de fréquence selon la revendication 1, **caractérisé en ce que** la sortie des moyens d'élaboration (41) du signal intermédiaire est rebouclée vers les moyens de commande (42) desdits moyens d'élaboration, de sorte à ce que lesdits moyens de commande soient cadencés à la fréquence du signal intermédiaire généré.

3.  Synthétiseur de fréquence selon la revendication 1 ou 2, **caractérisé en ce que** les moyens d'élaboration (41) du signal intermédiaire comprennent un circuit multiplexeur.

4.  Synthétiseur de fréquence selon l'une quelconque des revendications précédentes, **caractérisé en ce que** le modulateur sigma-delta (46) est un modulateur d'ordre 2, la détermination des premier et troisième paramètres de réglage, respectivement MD et MDC est telle que :

*MD+MDC ≤ nt-2*, avec nt le nombre de signaux générées par les moyens de génération de signaux (50).

5.   Synthétiseur de fréquence selon l'une quelconque des revendications précédentes, **caractérisé en ce que** le rapport de division global est tel que :

$$\beta = \frac{N \times MD + MDC + \dfrac{PE}{2^n}}{nt},$$

avec nt le nombre de signaux générées par les moyens de génération de signaux (50).

6.   Synthétiseur de fréquence selon l'une quelconque des revendications précédentes, **caractérisé en ce qu'**un circuit diviseur de fréquence (60) introduisant un facteur de division D est intercalé entre la sortie des moyens de modulation (40) et l'autre entrée du comparateur de phase (16).

7.   Synthétiseur de fréquence selon l'une quelconque des revendications 1 à 3, **caractérisé en ce que** des moyens sont adapter à inhiber le modulateur sigma-delta.

8.   Synthétiseur de fréquence selon la revendication 7, **caractérisé en ce que** la détermination des premier et troisième paramètres de réglage, respectivement MD et MDC est telle que :
*MD + MDC ≤ nt*, avec nt le nombre de signaux générées par les moyens de génération de signaux (50).

9.   Synthétiseur de fréquence selon la revendication 7 ou 8, **caractérisé en ce que** le rapport de division global est tel que :

$$\beta = \frac{N \times MD + MDC}{nt},$$

avec nt le nombre de signaux générées par les moyens de génération de signaux (50).

10.  Synthétiseur de fréquence selon l'une quelconque des revendications précédentes, **caractérisé en ce que** les moyens de génération de signaux (50) comprennent un circuit diviseur de fréquence, introduisant un facteur de division prédéterminé (S) dans la boucle.

11.  Synthétiseur de fréquence selon l'une quelconque des revendications précédentes, **caractérisé en ce qu'**un circuit diviseur de fréquence (22) est connecté à la première entrée du comparateur de phase (16), de sorte à pouvoir abaisser la fréquence du signal de référence d'un facteur prédéterminé (R).

12.  Synthétiseur de fréquence selon l'une quelconque des revendications précédentes, **caractérisé en ce qu'**un circuit diviseur de fréquence (24) est connecté en sortie de l'oscillateur, de sorte que la fréquence de sortie désirée dudit synthétiseur est égale à une division par un facteur prédéterminé (P) de la fréquence de sortie de l'oscillateur.

13.  Synthétiseur de fréquence selon l'une quelconque des revendications précédentes, **caractérisé en ce qu'**il est réalisé sous la forme d'un circuit intégré.

**Claims**

1.   Frequency synthesiser comprising a phase locked loop (10) comprising

- a phase comparator (16) for which a first input is connected to a reference signal source,
- a voltage controlled oscillator (12),
- modulation means (40) with a global division ratio (β) which when multiplied by the reference signal frequency (Fin) produces the required output frequency (Fout), the said modulation means comprising a frequency divider circuit (14) to divide the frequency of the oscillator output signal by an adjustable integer division factor N, and the output of which is connected to the other input of the phase comparator,
the said synthesiser further comprising signal generation means (50) connected between the oscillator and the modulation means, to generate a predetermined number of signals synchronised on the frequency of the said oscillator and the phases of which are spaced from each other by a time difference (∆t) representative of the

phase error measured by the phase comparator,
the said modulation means comprising:

- generation means (41) capable of generating, starting from the said signals, an intermediate signal (FS) adapted to be applied to said divider by N circuit, the period of which is dependent on the said time difference (Δt) between the phases and a first adjustment parameter MD,
- control means (42) of said generation means (41), comprising a first adder circuit (45) of which a first input receives the first adjustment parameter (MD) and of which the output is connected to a decoder circuit (44) to control the generation means (41) based on information output by the said first adder circuit,
- correction means (43) that can determine the phase error accumulated during N-1 periods of the said intermediate signal and make a correction of the said intermediate signal every N periods of the said intermediate signal as a function of the said accumulated phase error, the said correction means comprising a sigma-delta modulator adapted to be clocked by the output signal of said divider by N circuit,

**characterised in that** said sigma-delta modulator (46) of the correction means further comprises an input to receive a second adjustment parameter PE coded on n bits and defining an adjustable fractional part of the division ratio, the output from the said sigma-delta modulator being connected to a first input of a second adder circuit (47) receiving a third adjustment parameter MDC on a second input, the output from said second adder circuit (47) being connected to a second input to the first adder circuit (45) through selection means (48) clocked by the output signal from the divider by N circuit (14).

2. Frequency synthesiser according to claim 1, **characterised in that** the output from the intermediate signal generation means (41) is looped back to the control means (42) of the said generation means, such that the said control means are clocked at the frequency of the generated intermediate signal.

3. Frequency synthesiser according to claim 1 or 2, **characterised in that** the intermediate signal generation means (41) comprise a multiplexer circuit.

4. Frequency synthesiser according to any one of the previous claims, **characterised in that** the sigma-delta modulator (46) is an order 2 modulator, and the first and third adjustment parameters MD and MDC respectively are determined such that:
$MD + MDC \leq nt - 2$, where nt is the number of signals generated by the signals generation means (50).

5. Frequency synthesiser according to any one of the previous claims, **characterised in that** the global division ratio is such that:

$$\beta = \frac{NxMD + MDC + \dfrac{PE}{2^n}}{nt}$$

where nt is the number of signals generated by the signals generation means (50).

6. Frequency synthesiser according to any one of the previous claims, **characterised in that** a frequency divider circuit (60) introducing a division factor D is inserted between the output from the modulation means (40) and the other input of the phase comparator (16).

7. Frequency synthesiser according to any one of claims 1 to 3, **characterised in that** means are adapted to inhibit the sigma-delta modulator.

8. Frequency synthesiser according to claim 7, **characterised in that** the first and third adjustment parameters MD and MDC respectively are determined such that:
$MD + MDC \leq nt,$ where nt is the number of signals generated by the signals generation means (50).

9. Frequency synthesiser according to claim 7 or 8, **characterised in that** the global division ratio is such that:

$$\beta \;=\; \frac{NxMD + MDC}{nt}$$

where nt is the number of signals generated by the signals generation means (50).

10. Frequency synthesiser according to any one of the previous claims, **characterised in that** the signals generation means (50) comprise a frequency divider circuit introducing a predetermined division factor (S) into the loop.

11. Frequency synthesiser according to any one of the previous claims, **characterised in that** a frequency divider circuit (22) is connected to the first input of the phase comparator (16), so as to be able to lower the frequency of the reference signal by a predetermined factor (R).

12. Frequency synthesiser according to any one of the previous claims, **characterised in that** a frequency divider circuit (24) is connected to the output of the oscillator such that the required output frequency from the said synthesiser is determined by dividing the oscillator output frequency by a predetermined factor (P).

13. Frequency synthesiser according to any one of the previous claims, **characterised in that** it is made in the form of an integrated circuit.


**Patentansprüche**

1. Frequenzsynthesizer mit einer phasenvernegelten Schleife (10) mit folgenden Merkmalen:

- ein Phasenvergleicher (16), dessen erster Eingang mit einer Referenzsignalquelle verbunden ist,
- ein spannungsgesteuerter Oszillator (12),
- Modulationsmittel (40), die ein globales Teilungsverhältnis (β) aufweisen, wobei das Produkt mit der Frequenz des Referenzsignals (Fin) die gewünschte Ausgangsfrequenz (Fout) liefert, wobei die Modulationsmittel einen Frequenzteilerschaltkreis (14) umfassen, um die Frequenz des Ausgangssignals des Oszillators durch einen einstellbaren ganzzahligen Teilungsfaktor N zu teilen, und deren Ausgang mit dem anderen Eingang des Phasenvergleichers verbunden ist,

wobei der Synthesizer ferner Mittel zum Erzeugen von Signalen (50) aufweist, die zwischen dem Oszillator und den Modulationsmitteln angeschlossen sind, um eine vorgegebene Anzahl von Signalen zu erzeugen, die mit der Frequenz des Oszillators synchronisiert sind und deren Phasen voneinander mit einem zeitlichen Abstand (Δt) beabstandet sind, der repräsentativ für den von dem Phasenvergleicher gemessenen Phasenfehler ist,
wobei die Modulationsmittel umfassen:

- Verarbeitungsmittel (41), die dazu geeignet sind, ausgehend von diesen Signalen, ein Zwischensignal (Fs) zu entwickeln, das dazu bestimmt ist, an den Schaltkreis zum Teilen durch N angelegt zu werden, dessen Periode abhängig ist von dem zeitlichen Abstand (Δt) zwischen den Phasen und von einem ersten Regelparameter MD,
- Steuermittel (42) für die Verarbeitungsmittel mit einem ersten Additionsschaltkreis (45), dessen erster Eingang den ersten Regelparameter (MD) empfängt und dessen Ausgang mit einem Decoderschaltkreis (44) verbunden ist, um die Verarbeitungsmittel (41) auf der Basis der von dem ersten Additionsschaltkreis gelieferten Information anzusteuern,
- Korrekturmittel (43), die dazu geeignet sind, den Phasenfehler zu ermitteln, der im Laufe von N-1 Perioden des Zwischensignals akkumuliert wird, und eine Korrektur des Zwischensignals zu allen N Perioden des Zwischensignals als Funktion des akkumulierten Phasenfehlers auszuführen, wobei die Korrekturmittel einen Sigma-Delta-Modulator umfassen, der dazu eingerichtet ist, von dem Ausgangssignal des Schaltkreises zum Teilen des N getaktet zu werden,

**dadurch gekennzeichnet, daß** der Sigma-Delta-Modulator der Korrekturmittel ferner einen Eingang zum Empfangen eines zweiten Regelparameter PE aufweist, welcher mit n Bits codiert ist und einen einstellbaren Bruchteil des Teilungsverhältnisses definiert, wobei der Ausgang des Sigma-Delta-Modulators mit einem ersten Eingang eines zweiten Additionsschaltkreises (47) verbunden ist, welcher an einem zweiten Eingang einen dritten Regelparameter MDC empfängt, wobei der Ausgang des zweiten Additionsschaltkreises (47) mit einem zweiten Eingang des ersten Additionsschaltkreises (45) über Auswahlmittel (48) verbunden ist, welche durch das Ausgangssignal des Schaltkreises zum Teilen durch N (14) getaktet werden.

2. Frequenzsynthesizer nach Anspruch 1, **dadurch gekennzeichnet, daß** der Ausgang der Verarbeitungsmittel (41) des Zwischensignals zu den Steuermitteln (42) der Verarbeitungsmittel zurückgeführt ist, so daß die Steuermittel mit der Frequenz des erzeugten Zwischensignals getaktet werden.

3. Frequenzsynthesizer nach Anspruch 1 oder 2, **dadurch gekennzeichnet, daß** die Verarbeitungsmittel (41) des Zwischensignals einen Multiplexerschaltkreis umfassen.

4. Frequenzsynthesizer nach einem der vorangehenden Ansprüche, **dadurch gekennzeichnet, daß** der Sigma-Delta-Modulator (46) ein Modulator zweiter Ordnung ist, wobei die Bestimmung des ersten und des dritten Regelparameters, MD bzw. MDC, derart ist, daß:
MD + MDC $\leq$ nt -2, wobei nt der Anzahl der von den Signalerzeugungsmitteln (50) erzeugten Signalen entspricht.

5. Frequenzsynthesizer nach einem der vorangehenden Ansprüche, **dadurch gekennzeichnet, daß** das globale Teilungsverhältnis derart ist, daß:

$$\beta = \frac{N \times MD + MDC + \dfrac{PE}{2^n}}{nt},$$ wobei nt der Anzahl der von den Signalerzeugungsmitteln (50) erzeugten Signale entspricht.

6. Frequenzsynthesizer nach einem der vorangehenden Ansprüche, **dadurch gekennzeichnet, daß** ein Frequenzteilerschaltkreis (60), der ein Teilungsfaktor D einführt, zwischen den Ausgang der Modulationsmittel (40) und den anderen Eingang des Phasenvergleichers (16) geschaltet ist.

7. Frequenzsynthesizer nach einem der Ansprüche 1 bis 3, **dadurch gekennzeichnet, daß** die Mittel dazu geeignet sind, den Sigma-Delta-Modulator zu sperren.

8. Frequenzsynthesizer nach Anspruch 7, **dadurch gekennzeichnet, daß** die Bestimmung des ersten und des dritten Regelparameters, MD bzw. MDC, derart ist, daß:
MD + MDC $\leq$ nt, wobei nt der Anzahl der von den Signalerzeugungsmitteln (50) erzeugten Signale entspricht.

9. Frequenzsynthesizer nach Anspruch 7 oder 8, **dadurch gekennzeichnet, daß** das globale Teilungsverhältnis derart

ist, daß: $\beta = \dfrac{N \times MD + MDC}{nt}$ , wobei nt der Anzahl der von den Signalerzeugungsmitteln (50) erzeugten Signale entspricht.

10. Frequenzsynthesizer nach einem der vorangehenden Ansprüche, **dadurch gekennzeichnet, daß** die Signalerzeugungsmittel (50) einen Frequenzteilerschaltkreis umfassen, der einen vorgegebenen Teilungsfaktor (S) in die Schleife einführt.

11. Frequenzsynthesizer nach einem der vorangehenden Ansprüche, **dadurch gekennzeichnet, daß** ein Frequenzteilerschaltkreis (22) mit dem ersten Eingang des Phasenvergleichers (16) verbunden ist, so daß er die Frequenz des Referenzsignals um einen vorgegebenen Faktor (R) senken kann.

12. Frequenzsynthesizer nach einem der vorangehenden Ansprüche, **dadurch gekennzeichnet, daß** ein Frequenzteilerschaltkreis (24) mit dem Ausgang des Oszillators verbunden ist, so daß die gewünschte Ausgangsfrequenz des Synthesizers gleich einem Teilungsverhältnis durch einen vorgegebenen Faktor (P) der Ausgangsfrequenz des Oszillators ist.

13. Frequenzsynthesizer nach einem der vorangehenden Ansprüche, **dadurch gekennzeichnet, daß** er in Form eines integrierten Schaltkreises realisiert ist.

**FIG. 2**
**(art antérieur)**

**FIG. 3**

**FIG. 4**

FIG. 5

**RÉFÉRENCES CITÉES DANS LA DESCRIPTION**

**Documents brevets cités dans la description**

- WO 03039002 A2